# DEMANDE DE BREVET EUROPEEN

(11) **EP 0 592 339 A1**
(43) Date de publication de la demande: **13.04.1994**
(21) Numéro de dépôt: 93420394.4
(22) Date de dépôt: 05.10.1993
(51) Int. Cl.: G01R 31/28

(54) **Appareil de test de circuits imprimés**

(30) Priorité: 09.10.1992 FR 9212549
(71) Demandeur: INTERNATIONAL MARKET DEVELOPMENT S.A.R.L., F-91953 Les Ulis Cedex (FR)
(72) Inventeur: Vaucher, Christophe, F-38000 Grenoble (FR)
(74) Mandataire: de Beaumont, Michel

(57) **Abrégé**

La présente invention concerne un appareil de test de circuits imprimés comprenant un plateau de test (20) formé par la juxtaposition en lignes et colonnes de blocs de test (52) à densités différentes de points de test, ces blocs appartenant à des modules (30) amovibles perpendiculairement au plateau. Selon l'invention, l'appareil comprend pour chaque ligne et/ou colonne de modules des moyens de déplacement (42, 62) des modules entre une position d'alignement des blocs avec le plateau et une position en saillie du plateau.

## Description

La présente invention concerne un appareil de test de circuits imprimés nus, notamment les appareils de test dits modulaires comprenant un plateau de test de dimensions variables formé par la juxtaposition de blocs de test.

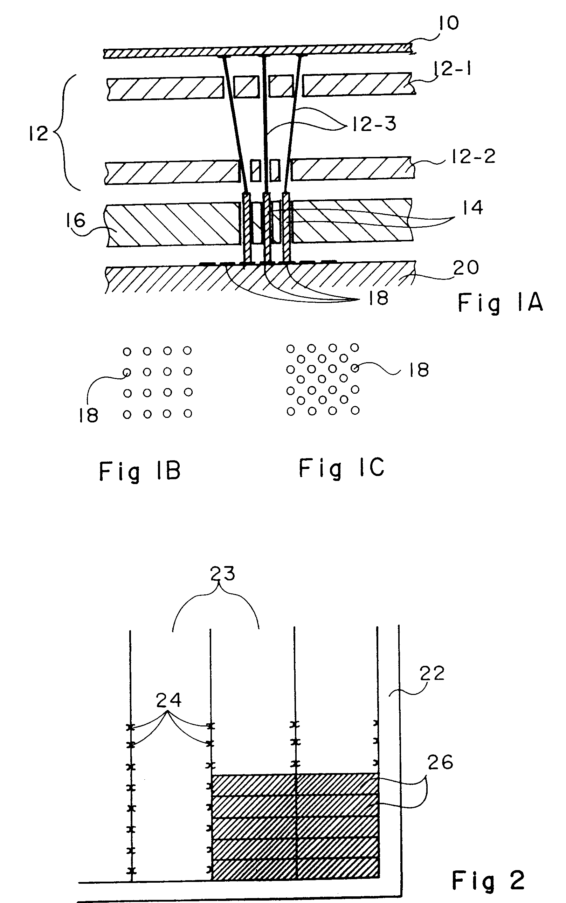

La figure 1A représente une disposition classique pour tester les pistes d'un circuit imprimé nu 10. Le circuit imprimé 10 est posé, face à tester en bas, sur un lit à clous 12. Le lit à clous 12 comprend une plaque de gabarit 12-1 du côté du circuit imprimé 10 et une plaque de base 12-2 parallèle et solidaire de la plaque 12-1. Les plaques 12-1 et 12-2 servent de guidage à des clous (aiguilles) 12-3 venant palper sur le circuit imprimé 10 des zones définies par des perçages de guidage de la plaque de gabarit 12-1. Les extrémités inférieures des clous 12-3 sont ramenées à un pas standard grâce à la plaque de base 12-2. Ces extrémités inférieures appuient sur des pointes à ressort ou double effet 14 incorporées dans une plaque 16 au même pas que les trous de la plaque 12-2. Les pointes double effet 14 appuient sur des pastilles 18 d'un plateau de test 20. Les pastilles 18 sont généralement gravées selon une grille à pas standard sur le plateau 20 en matériau isolant. Ces pastilles 18 sont reliées à un système électronique de test, non représenté, par des moyens connus de la technique. Les pointes double effet 14 sont en même nombre et au même pas que les pastilles 18 et servent à éliminer le jeu vertical des clous 12-3 pour assurer le contact entre chaque point à tester du circuit imprimé 10 et la pastille de test 18 correspondante.

Les figures 1B et 1C représentent partiellement deux types de grille universelle à pas standard. La partie de grille de la figure 1B comprend des pastilles alignées horizontalement et verticalement et distantes les unes des autres de 2,54 mm, centre à centre. La figure 1C représente une partie de grille double densité comprenant des pastilles alignées diagonalement et distantes les unes des autres de 1,79 mm. Cette grille est obtenue en disposant des rangées de pastilles au pas 2,54 mm entre les rangées de pastilles de la figure 1B avec un décalage de 1,27 mm. Pour désigner une telle grille, on utilise dans la technique l'expression "double densité". Ci-après, on entend par "point de test" l'ensemble d'une pastille 18 et de la pointe à ressort 14 associée, ou bien la pastille 18 seule.

Le coût d'un plateau de test 20 est proportionnel au nombre de points de test dont il est équipé, et donc à sa surface. Le coût unitaire du point de test étant relativement élevé, certains fabricants d'appareils de test proposent des plateaux de test modulaires.

La figure 2 représente un plateau de test modulaire classique. Ce plateau de test comprend un châssis 22 équipé de plusieurs colonnes 23 de tiroirs 24 pour circuit imprimé. Dans chacun de ces tiroirs 24 on peut glisser un module 26 comprenant un bloc de test (partie visible à la figure 2) relié à un circuit imprimé lui-même connecté à un bus du fond du châssis 22. Chaque bloc de test comporte une sous grille de points de test à un pas standard et le plateau de test est formé par la juxtaposition des blocs de test. Dans la figure 2, on a représenté dix modules 26 formant un plateau de test de dimensions réduites par rapport à la capacité du châssis 22.

Ainsi, un client peut acheter un châssis 22 de grande capacité mais qu'il ne garnira que d'un certain nombre de modules 26 pour créer un plateau de test aux dimensions de son plus grand circuit imprimé à tester. Si un jour le client souhaite tester des circuits imprimés de plus grande taille, il pourra racheter des modules 26 et les disposer à côté des modules précédents pour agrandir son plateau de test.

Ces dernières années, est apparue une tendance à passer pour le montage de composants sur des circuits imprimés d'un montage en insertion à un montage en surface. Dans le montage en insertion, chaque broche d'un composant passe dans un trou prévu dans le circuit imprimé et la soudure se fait à la vague à partir de la face arrière du circuit imprimé, c'est-à-dire la face opposée à celle portant les composants. Dans le montage en surface, les broches des composants sont repliées pour avoir leurs extrémités parallèles au plan de montage ou pour être tangentes à celui-ci sur au moins une partie de leur longueur. Ces extrémités repliées sont posées sur des plages métallisées prévues sur un circuit imprimé et sont soudées ainsi en surface, par exemple à la vague.

Parmi les nombreux avantages connus de la technologie de montage en surface, on peut noter le fait que les broches des composants et les plages de métallisation sur lesquelles elles reposent peuvent être miniaturisées par rapport au cas des composants montés par insertion. Toutefois, cet avantage entraîne l'apparition de zones à tester de forte densité. Ainsi, il peut s'avérer dans certains cas qu'un plateau à grille simple densité de points de test ne soit plus suffisant. Il faut alors réaliser un plateau de test à grille double densité, grâce à des modules 26 double densité, ce qui revient deux fois plus cher que le même plateau en simple densité.

Or, des études effectuées par la demanderesse révèlent que les zones à haute densité de circuits imprimés adaptés à la technologie de montage en surface sont très localisées et n'occupent, en pratique aujourd'hui, que 10 à 15 % de la surface du circuit imprimé, en moyenne. Il s'avère donc que, si l'on dispose d'un plateau de test double densité, 85 à 90 % de la surface du plateau aurait pu être à simple densité et donc deux fois moins chère pour un type de circuit imprimé donné.

La demanderesse propose, au lieu de former un plateau de test avec seulement des modules double densité, de former un plateau de test avec une majorité de modules simple densité en insérant aux endroits adéquats des modules double densité.

Bien entendu, dans le système de la figure 2, on peut très bien insérer des modules double densité parmi une majorité de module simple densité. Toutefois, une fois que le plateau de test est ainsi formé, il est particulièrement fastidieux de déplacer les modules double densité pour les faire correspondre à des zones haute densité différentes d'un nouveau circuit imprimé à tester. En effet, il est difficile d'extraire un module entouré d'autres modules car il n'est pas prévu de dispositif de préhension sur la surface apparente des modules ; la trop importante densité des points de test ne le permet pas. En outre, il n'est pas envisageable de sacrifier des points de test pour inclure un dispositif de préhension des modules, tel que des trous taraudés, car cela rendrait plus complexe la tâche du concepteur des lits à clous 12.

En outre, l'accès des modules 26 au niveau du fond du châssis est restreint, ce qui ne permet pas d'extraire un module en le poussant par derrière.

Ainsi, pour extraire un module, il faut commencer par extraire les modules se trouvant entre le bord du plateau et le module visé. Cette opération est particulièrement fastidieuse et nécessite en outre l'intervention de personnel de maintenance qualifié, car l'opération peut poser certains problèmes de sécurité, ou pourrait conduire à une détérioration du matériel si elle n'est pas effectuée selon certaines règles. En outre, le fabricant ne saurait plus garantir un appareil qui a été modifié de cette manière.

Un objet de la présente invention est de prévoir un plateau de test modulaire dans lequel il est particulièrement aisé d'extraire des modules isolés, même sous tension, afin de pouvoir facilement et rapidement déplacer des modules à densité élevée dans un plateau comportant une majorité de modules à densité basse.

Un autre objet de la présente invention est de prévoir une connexion facile de modules à densités différentes au système de test.

Cet objet est atteint selon l'invention grâce à un plateau de test modulaire dont les modules de chaque ligne ou colonne peuvent être surélevés par rapport aux autres lorsqu'un opérateur actionne un dispositif de déverrouillage.

La présente invention vise plus particulièrement un appareil de test de circuits imprimés comprenant un plateau de test formé par la juxtaposition en lignes et colonnes de blocs de test à densités différentes de points de test, ces blocs appartenant à des modules amovibles perpendiculairement au plateau. Selon l'invention, l'appareil comprend pour chaque ligne et/ou colonne de modules des moyens de déplacement des modules entre une position d'alignement des blocs avec le plateau et une position en saillie du plateau.

Selon un mode de réalisation de la présente invention, lesdits moyens de déplacement comprennent des moyens élastiques sollicitant chaque module vers la position en saillie, et une barre par ligne et/ou colonne coulissant parallèlement au plateau entre une position de verrouillage en position d'alignement des modules de la ligne ou colonne et une position de libération des modules.

La présente invention vise aussi un module pour l'appareil susmentionné, comprenant au moins une tige sollicitée par ressort en appui contre un socle du coté opposé du plateau.

Selon un mode de réalisation de la présente invention, le module comprend au moins un oeillet dans lequel passe ladite barre.

Selon un mode de réalisation de la présente invention, le module comprend un élément de rigidification et de guidage sur lequel est monté un bloc de test, au moins un circuit imprimé monté dans l'élément de rigidification et relié au bloc de test, et un connecteur relié au circuit imprimé du côté opposé du bloc de test, destiné à coopérer avec un connecteur du socle par l'intermédiaire de pointes à ressort.

Selon un mode de réalisation de la présente invention, l'élément de rigidification est un tube à section rectangulaire muni à l'intérieur de glissières pour recevoir ledit au moins un circuit imprimé (34).

Selon un mode de réalisation de la présente invention, le module comprend un bloc de test intégrant pour chaque point de test une pointe à ressort.

Selon un mode de réalisation de la présente invention, chaque point de test du bloc de test comprend une pointe à ressort reliée à un conducteur dénudé d'une limande de fils par l'intermédiaire d'un contact à double tête tulipe.

Selon un mode de réalisation de la présente invention, chaque point de test du bloc de test comprend une pointe à ressort insérée dans un contact à tête tulipe qui est brasé sur une pastille d'un substrat.

Selon un mode de réalisation de la présente invention, ledit substrat oemporte sur la face opposée des puces nues de circuit intégré reliées par des fils à des pistes gravées sur ladite face opposée.

Ces objets, caractéristiques et avantages ainsi que d'autres de la présente invention seront exposés en détail dans la description suivante de modes de réalisation particuliers faite en relation avec les figures jointes parmi lesquelles :
la figure 1A, précédemment décrite, représente une disposition classique pour tester un circuit imprimé ;
les figures 1B et 1C, précédemment décrites, représentent partiellement deux grilles standard de points de test ;
la figure 2 représente un plateau de test modulaire classique ;
les figures 3A et 3B représentent des vues en coupe de côté et de face d'un mode de réalisation de module de test selon l'invention ;
la figure 4 représente un mode de réalisation de dispositif de fixation d'un module de test sur un socle ;
la figure 5 représente une vue en perspective d'un plateau de test formé de plusieurs modules de test selon l'invention ;
la figure 6 représente une juxtaposition d'un bloc de test simple densité et d'un bloc de test double densité selon l'invention ;
la figure 7 représente un mode de réalisation d'un bloc de test selon l'invention ; et
la figure 8 représente un autre mode de réalisation de bloc de test selon l'invention.

La présente invention prévoit de former un plateau de test à l'aide de modules rigides reposant sur un socle dans lequel il est prévu un système de verrouillage des modules en position de formation du plateau. Chaque module est muni de tiges à ressort s'appuyant sur le socle et sollicitant le module vers le haut. Le système de verrouillage agit par ligne ou par colonne de modules. En libérant le système de verrouillage pour une ligne ou une colonne, les modules de la ligne ou colonne se surélèvent par rapport au plateau sous l'action des tiges à ressort. Ainsi, les modules surélevés présentent une prise latérale et peuvent être facilement extraits. Pour faciliter davantage l'extraction, les modules sont reliés à leur partie inférieure à un bus monté sur le socle par l'intermédiaire de connecteurs à effort d'extraction faible ou nul.

Un utilisateur pourra acquérir un ensemble de modules selon l'invention pour former un plateau de test aux dimensions de son plus grand circuit imprimé à tester. Un nombre limité de ces modules, représentant par exemple 10 à 15 % du nombre de modules, seront des modules à double densité (ou autre) de points de test, alors que les autres seront des modules simple densité. Initialement, l'utilisateur disposera lui-même les modules pour former le plateau de test, en disposant les modules double densité au niveau d'éventuelles zones à haute densité de connexion d'une première série de circuits imprimés à tester. Lorsque l'utilisateur devra tester une deuxième série de circuits imprimés ayant des zones à haute densité de dispositions différentes de celle de la première série, l'utilisateur n'a plus qu'à extraire les modules simple densité qui doivent être remplacés et des modules double densité en surélevant successivement les lignes correspondantes, et à interchanger les modules.

Les opérations de placement et d'échange de modules ne nécessitent pas l'intervention de personnel qualifié car, comme on le verra ci-après, les modules sont de constitution robuste et particulièrement simples à manier.

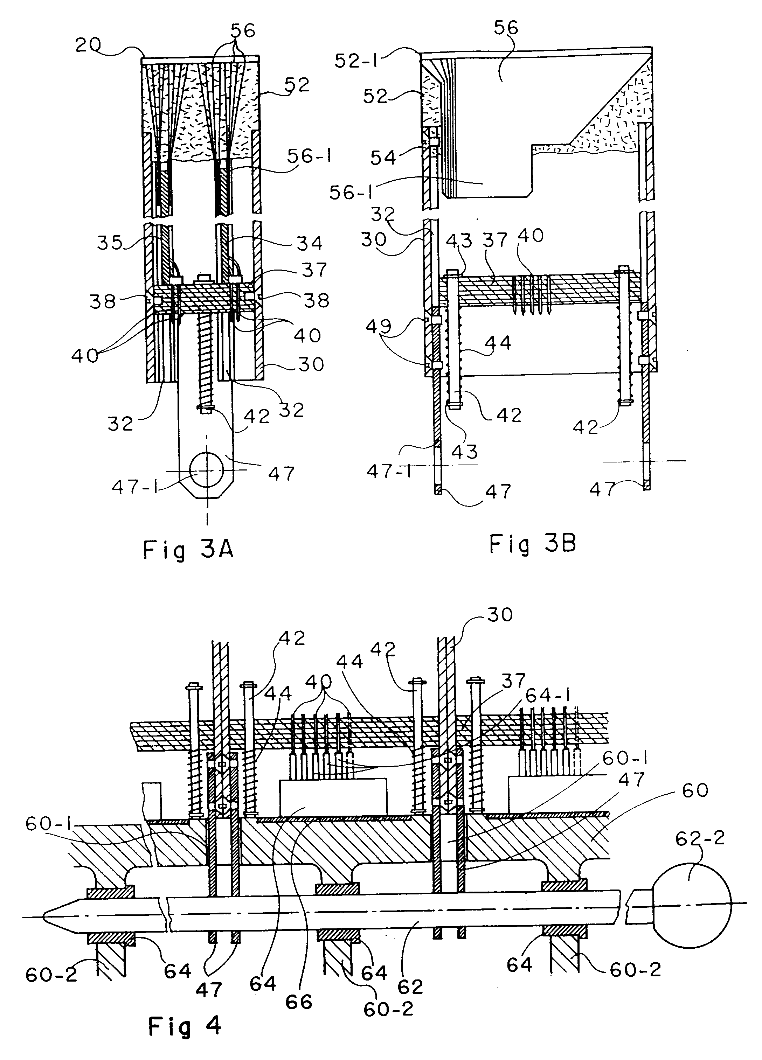

Les figures 3A et 3B représentent des vues en coupe de face et de côté d'un mode de réalisation de module de test selon la présente invention. Le module comprend un tube 30 de section rectangulaire à axe vertical, dont les petites parois verticales sont munies de glissières 32 permettant l'insertion, comme cela est représenté à la figure 3A, d'un premier circuit imprimé 34 légèrement décalé à droite par rapport au centre du tube, et d'un deuxième circuit imprimé 35 légèrement décalé à droite de la paroi gauche du tube. Le module représenté est un module double densité comprenant les deux circuits imprimés 34 et 35. Si le module était à simple densité, il comprendrait un seul circuit imprimé par exemple 34. Les circuits imprimés 34, 35 supportent des composants électroniques (non représentés) destinés à multiplexer et démultiplexer, comme cela est connu de la technique, les informations transitant entre les points de test et un système de test, ceci pour réduire le nombre de signaux véhiculés entre les modules et le système.

Les circuits imprimés 34 et 35 sont arrêtés à la partie inférieure du module au niveau d'un bouchon 37 en matière isolante. Le bouchon 37 est maintenu par des vis 38 à tête fraisée traversant les parois du tube 30. La partie inférieure des circuits imprimés 34, 35 est reliée à un connecteur formé par des broches 40 traversant verticalement le bouchon 37 et faisant saillie à la partie inférieure du bouchon. Toutes les broches 40 ne sont pas représentées et celles qui le sont ne le sont pas à l'échelle. Dans un exemple de réalisation de module, on utilise 32 broches pour 512 points de test. Les groupes de broches 40 reliés respectivement aux circuits imprimés 34 et 35 sont disposés symétriquement par rapport à l'axe du tube. On décrira ultérieurement un mode de connexion des broches 40 à un bus relié au système de test.

Deux tiges à ressort 42 traversent verticalement le bouchon 37 à proximité respectivement des petites parois verticales du tube 30. Les extrémités de chaque tige 42 sont munies de circlips 43. Un ressort 44 s'appuie entre le circlips inférieur de chaque tige 42 et la partie inférieure du bouchon 37. Lorsque le ressort 44 est détendu, comme cela est représenté, les tiges 42 dépassent de l'extrémité inférieure du tube 30.

A la partie inférieure de chaque petite paroi verticale du tube 30 est fixé, à l'intérieur du tube, un oeillet 47 s'étendant vers le bas au-delà de l'extrémité inférieure du tube. Selon la vue de la figure 3A, les oeillets 47 sont centrés, comme les tiges à ressort 42, par rapport à l'axe vertical du tube et sont de largeur inférieure à celle du tube. Les trous 47-1 des deux oeillets du module ont le même axe horizontal décalé vers le bas par rapport à l'extrémité inférieure du tube 30. Les oeillets 47 sont fixés au tube 30 par des vis 49 à tête fraisée traversant les petites parois verticales du tube.

On verra ci-après le rôle des tiges à ressort 42 et des oeillets 47.

A la partie supérieure du module est fixé un bloc de test 52 comprenant une partie supérieure dont les faces latérales sont alignées avec les faces externes du tube 30 et une partie inférieure épousant sensiblement l'intérieur du tube 30. Cette partie inférieure est fixée au tube par des vis 54 à tête fraisée traversant les parois du tube. Selon un mode de réalisation, la face supérieure du bloc 42 est formée par un circuit imprimé 52-1, ou un substrat équivalent, sur lequel sont gravées des pastilles de test au pas souhaité. Deux rangées consécutives de pastilles de test sont reliées par des trous métallisés à une seule rangée de pastilles gravées à la partie inférieure du circuit imprimé 52-1 au pas de 1,27 mm. Chaque rangée inférieure du circuit imprimé est soudée à des pistes gravées sur un circuit imprimé souple 56. Les pistes du circuit imprimé 56, au pas de 1,27 mm au niveau du circuit imprimé 52-1, sont ramenées au pas de 0,5 mm dans une languette 56-1 disposée, comme cela est représenté à la figure 3B, dans une moitié du tube 30. Les languettes 56-1 des circuits imprimés 56 successifs sont disposées alternativement dans une moitié et l'autre du tube 30. Les circuits imprimés 56 sont surmoulés de résine formant le corps du bloc de test 52 de sorte que les languettes 56-1 soient apparentes. La forme extérieure du bloc de test 52 sera décrite plus en détail ultérieurement.

Les longueurs des languettes 56-1 successives sont échelonnées de manière à pouvoir connecter les extrémités de ces languettes sur des rangées successives de pistes conductrices des circuits imprimés 34 et 35. Les pistes des languettes 56-1 sont reliées aux pistes des circuits imprimés 34 et 35 par l'intermédiaire par exemple, de bandes d'élastomère à conduction électrique anisotrope, ici à conduction seulement dans le sens de l'épaisseur de l'élastomère. Bien entendu, comme le représente la figure 3A, les languettes 56-1 peuvent être connectées de part et d'autre des circuits imprimés 34 et 35.

La figure 4 représente partiellement plusieurs modules selon l'invention montés sur un socle 60 pour former un plateau de test. L'extrémité inférieure du tube 30 de chaque module appuie sur une partie plane du socle 60. Les oeillets 47 traversent des trous 60-1 aménagés dans le socle 60. Les extrémités inférieures des tiges à ressort 42 appuient sur la même surface plane que l'extrémité inférieure du tube 30, ce qui a provoqué la remontée des tiges 42 et la compression des ressorts 44. Ainsi, le module est sollicité vers le haut. Le module est maintenu en place par une barre 62 traversant, sous le socle 60, les trous des oeillets 47. La barre 62 passe dans des coussinets 64 disposés dans des nervures verticales 60-2 s'étendant vers le bas du socle 60. La barre 62 comprend une extrémité conique 62-1 facilitant son insertion et une extrémité de manipulation 62-2 en forme de boule, apparente à l'extérieur de l'appareil de test et permettant à un utilisateur d'insérer et d'extraire la barre 62.

Avec cette configuration, lorsque l'on extrait la barre 62, la ligne de modules qui était maintenue par cette barre se surélève sous l'action des tiges à ressort 42 et chaque module de la ligne peut être extrait. Pour remettre les modules en place, on les plaque contre le socle 60, par exemple à l'aide d'une règle, et on insère la barre 62. On peut également plaquer les modules un à un contre le socle 60 au fur et à mesure que l'on insère la barre 62.

Bien entendu, chaque module est connecté à un bus reliant un ensemble de modules à un système électronique. Il convient, pour que les modules puissent facilement être surélevés par les tiges à ressort 42, et ensuite facilement extraits par un opérateur, que les modules soient connectés au bus par des connecteurs à faible effort d'extraction. Un mode de réalisation d'un tel connecteur est décrit ci-après.

En face de chaque ensemble de broches 40 est disposé un connecteur 64 muni de pointes à ressort 64-1, analogues aux pointes 14 de la figure 1A. Les pointes à ressort 64-1 sont reliées à des lignes d'un bus réalisé sur un circuit imprimé 66 disposé dans un évidement du socle 60. Le bus 66 s'étend perpendiculairement aux barres 62 et sert à relier entre eux les modules d'une même colonne. L'extrémité inférieure de chaque broche 40 appuie, dans la position de la figure 4, sur une pointe à ressort 64-1. Un tel système de connexion est fiable et ne présente aucun effort s'opposant à l'extraction du module.

Il est prévu deux connecteurs 64 parallèles par module. Ces deux connecteurs sont utilisés si le module est à double densité (les deux circuits imprimés 34, 35 sont présents), et un seul est utilisé si le module est à simple densité. Les deux connecteurs 64 associés à un module sont connectés en parallèle sur le bus 66 et les signaux du bus sont gérés de manière connue de la technique.

Dans un autre mode de réalisation, on peut prévoir un circuit imprimé unique dans chaque module simple ou double densité et un seul connecteur 64 par module. Le multiplexage et démultiplexage est alors effectué de manière deux fois plus rapide dans le module double densité que dans le module simple densité.

Les broches 40 doivent être positionnées de façon précise par rapport aux pointes à ressort 64-1. Ce positionnement est déterminé par le positionnement de la partie inférieure du tube 30. Le positionnement du tube 30 est par exemple assuré par des tétons (non représentés) du socle 60 venant s'appuyer dans deux coins intérieurs du tube 30 ou dans deux glissières 32 opposées. En outre, les tubes 30 de modules juxtaposés peuvent être jointifs, comme cela est représenté, ce qui facilite le positionnement et améliore la rigidité du plateau.

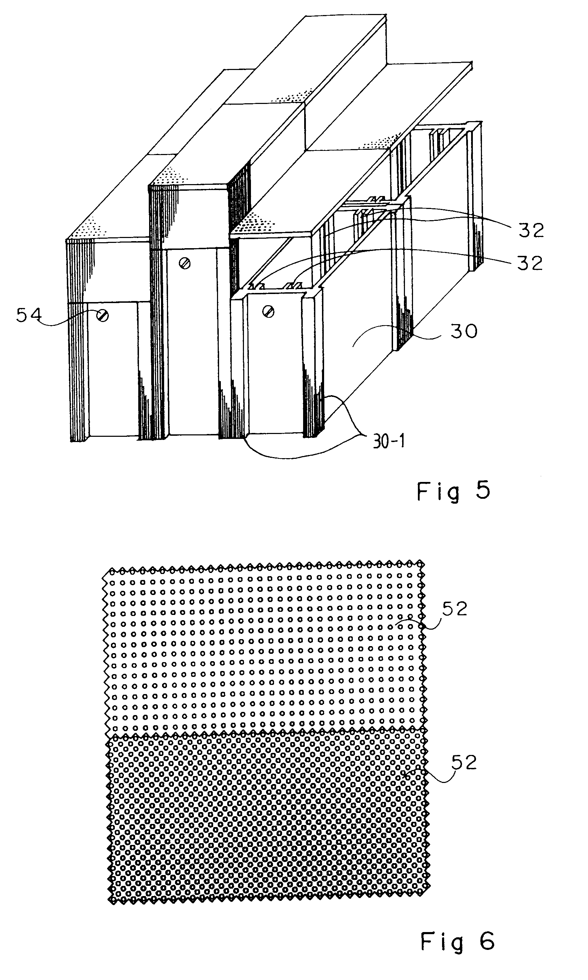

La figure 5 représente une vue en perspective de trois lignes et deux colonnes de modules. Les blocs de test des modules de droite sont représentés en transparent afin de voir en perspective les tubes 30. Les lignes extrêmes de modules sont en position verrouillée sur le socle et la ligne centrale est en position surélevée. On remarquera que les modules de la ligne centrale présentent une bonne prise au niveau de leurs côtés apparents. Comme le montre la figure 5, les tubes 30 comprennent un épaississement 30-1 au niveau de leurs arêtes verticales. Deux tubes 30 adjacents sont jointifs au niveau de ces épaississements.

La figure 6 représente en vue de dessus un bloc de test simple densité et un bloc de test double densité juxtaposés. Selon la vue de la figure 6, les faces latérales des blocs de test sont dentelées pour permettre un emboîtement sans jeu de deux blocs adjacents. Ceci permet de positionner avec précision les points de test d'un bloc par rapport aux points de test d'un bloc adjacent, et empêche tout déplacement latéral relatif des blocs. Les dentelures sont au pas de 2,54 mm et décalées d'un demi-pas entre une face latérale et la face opposée d'un bloc. Ceci permet, comme cela est représenté, d'obtenir une zone cohérente à points de test au pas de 2,54 mm au niveau du raccordement entre un bloc simple densité et un bloc double densité. Pour permettre le glissement vertical d'un module par rapport à l'autre, les épaississements 30-1 des tubes 30 sont rainurés verticalement en correspondance avec les dentelures des blocs.

Si l'on utilise des blocs de test à pastilles, tels que précédemment décrits, il faut prévoir, comme le représente la figure 1A une grille universelle 16 entre le plateau de test 20, formé par les modules, et le lit à clous 12. Si l'on prévoit des modules simple densité mélangés à des modules double densité, il faut que la grille universelle 16 soit une grille à double densité. Ceci représente une augmentation de coût inutile.

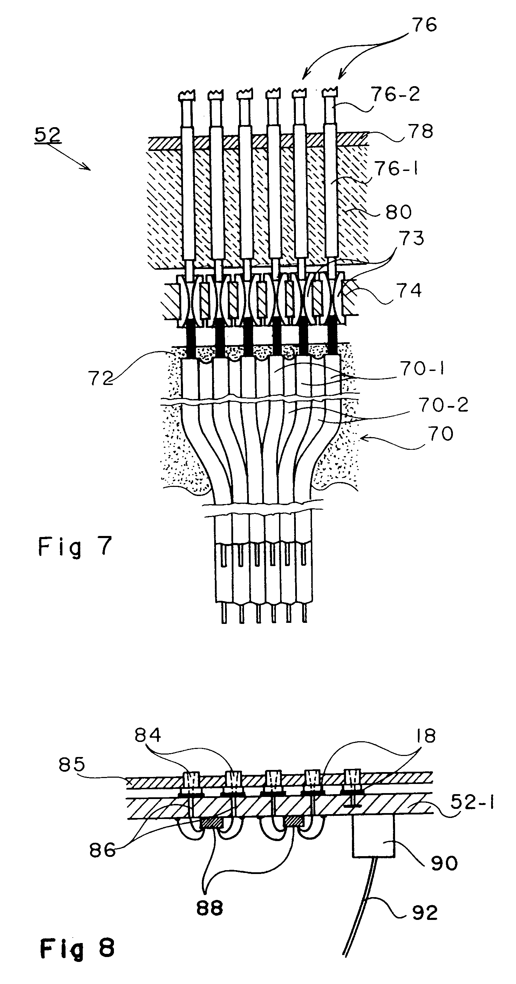

La figure 7 représente une vue partielle agrandie d'un mode de réalisation de points de test d'un bloc de test 52 permettant d'éviter l'emploi d'une grille universelle. Pour chaque rangée de points de test, il est prévu une limande 70 de conducteurs mono-brin isolés, au pas de 2,54 mm. Une limande comprend généralement un ensemble de conducteurs isolés 70-1 maintenus ensemble par des bandes d'isolant 70-2. A la partie inférieure du bloc de test, les bandes 70-2 sont pliées de sorte à ramener les conducteurs 70-1 l'un contre l'autre au pas de 1,27 mm. Les extrémités inférieures des conducteurs 70-1 sont dénudées et se présentent, comme les languettes 56-1 de la figure 3B, en longueurs échelonnées par limande, ce qui permet de souder les conducteurs sur des rangées successives de pistes de circuit imprimé. Les extrémités supérieures des conducteurs 70-1 sont dénudées et dépassent à la partie supérieure d'un bloc en résine 72 moulé autour de la partie supérieure des limandes. Ces conducteurs dénudés sont insérés dans les têtes inférieures de contacts 73 à double tête tulipe emprisonnés dans une plaque 74. Les contacts 73 présentent à chaque extrémité un épaulement s'appuyant sur la plaque 74. Des pointes à ressort 76, telles que les pointes 14 de la figure 1A, sont insérées dans les têtes supérieures des contacts 73. Les pointes 76 comprennent un cylindre fixe 76-1 dans lequel coulisse, en appui sur un ressort, un cylindre mobile 76-2. La partie supérieure des cylindres 76-2 est munie d'une plateforme destinée à entrer en contact de manière fiable avec l'extrémité inférieure d'un clou d'un lit à clous 12. Les cylindres fixes 76-1 sont guidés à leur partie supérieure par une plaque 78 et leur partie inférieure restante est noyée dans une mousse injectée 80.

La plaque 74 est collée sur le bloc 72 et la mousse 80 est collée sur la plaque 78. L'ensemble des pointes à ressort 76, de la plaque 78 et de la mousse 80 est maintenu par le seul effort de serrage des contacts à tête tulipe 73. Ainsi, chaque pointe 76 reste amovible et peut être remplacée en cas de défaillance. Pour former la plaque 74 emprisonnant les contacts 73, chaque contact 73 peut être prévu en deux parties emmanchables l'une dans l'autre. La plaque 74 est percée au pas adéquat, on emmanche les premières parties des contacts 73 dans les perçages de la plaque 74 et on emmanche ensuite chaque deuxième partie des contacts dans la première partie respective.

On forme ainsi un bloc de test simple ou double densité (ou autre densité) sur lequel on peut directement placer un lit à clous 12.

La figure 8 représente partiellement un autre mode de réalisation de bloc de test à pointes à ressort incorporées. Dans ce mode de réalisation on retrouve des pastilles 18 gravées sur un circuit imprimé multicouches 52-1 (ou autre substrat, tel qu'un substrat en céramique). Sur chaque pastille 18 est brasé un contact 84 à tête tulipe unique. Dans ces contacts 84 sont insérées des pointes à ressort de la même manière que dans la figure 7. La partie supérieure des contacts 84 ne comporte pas d'épaulement, de manière que l'on puisse glisser une plaque percée 85 par dessus les contacts 84, qui vient appuyer sur un épaulement de la partie inférieure des contacts 84. La plaque 85 est collée sur le substrat 52-1 et assure une rigidification de l'ensemble.

On a représenté à la figure 8 un mode de connexion des points de test à des circuits électroniques de multiplexage et démultiplexage. Chaque pastille 18 est reliée par un trou métallisé 86 à la face inférieure du substrat 52-1, ou bien, ce qui est représenté pour la pastille de droite, à une couche intermédiaire du substrat par un trou métallisé borgne. Sur la face inférieure du substrat sont collées des puces nues 88 de circuit intégré. Ces puces 88 sont reliées par des fils d'or, comme cela est connu dans la technique des circuits hybrides, entre elles, à des pistes gravées sur la face inférieure du substrat 52-1, et le cas échéant directement aux trous métallisés 86. Un connecteur 90 est soudé sur la face inférieure du substrat 52-1. De ce connecteur partent des fils 92, de l'ordre de 30, qui sont reliés par un connecteur à un circuit imprimé comportant les broches de connexion 40 susmentionnées et d'éventuels autres circuits électroniques. Une coquille, non représentée, protège les puces 88 et une résine enrobe la coquille et les fils 92 de manière à former le bloc de test 52. Avec cette configuration, l'encombrement en hauteur des modules de test est réduit.

La présente invention a été décrite avec des points de test disposés selon un pas simple densité de 2,54 mm et un pas double densité de 1,79 mm. Bien entendu, on pourra utiliser d'autres pas à condition qu'ils soient compatibles entre eux, c'est-à-dire que les perçages à un pas donné de la plaque de base 12-2 d'un lit à clous correspondent toujours à des points de test d'un bloc sous-jacent, quelle que soit la densité de ce bloc.

De nombreuses variantes et modifications de la présente invention apparaîtront à l'homme du métier. Au lieu de prévoir un système à ressorts et barre de verrouillage pour déplacer une ligne de modules entre une position basse et une position haute, on peut prévoir un système à excentrique qui bloque les modules en position basse et les libère en position haute, par exemple à l'aide d'un doigt excentré coopérant avec une rainure horizontale des modules, cette rainure étant ouverte vers le bas à une extrémité pour permettre la sortie du doigt et l'extraction du module.

## Revendications

1. Appareil de test de circuits imprimés (10) comprenant un plateau de test (20) formé par la juxtaposition en lignes et colonnes de blocs de test (52) à densités différentes de points de test, ces blocs appartenant à des modules (26) amovibles perpendiculairement au plateau, caractérisé en ce qu'il comprend pour chaque ligne et/ou colonne de modules des moyens de déplacement (42, 62) des modules entre une position d'alignement des blocs avec le plateau et une position en saillie du plateau.

2. Appareil selon la revendication 1, caractérisé en ce que lesdits moyens de déplacement comprennent des moyens élastiques (42, 44) sollicitant chaque module vers la position en saillie, et une barre (62) par ligne et/ou colonne coulissant parallèlement au plateau (20) entre une position de verrouillage en position d'alignement des modules de la ligne ou colonne et une position de libération des modules.

3. Module pour appareil selon la revendication 2, caractérisé en ce qu'il comprend au moins une tige (42) sollicitée par ressort (42) en appui contre un socle (60) du côté opposé du plateau (20).

4. Module selon la revendication 3, caractérisé en ce qu'il comprend au moins un oeillet (47) dans lequel passe ladite barre (62).

5. Module selon la revendication 3, caractérisé en ce qu'il comprend un élément de rigidification et de guidage (30) sur lequel est monté un bloc de test (52), au moins un circuit imprimé (34, 35) monté dans l'élément de rigidification et relié au bloc de test, et un connecteur (40) relié au circuit imprimé du côté opposé du bloc de test, destiné à coopérer avec un connecteur du socle (60) par l'intermédiaire de pointes à ressort (64-1).

6. Module selon la revendication 5, caractérisé en ce que l'élément de rigidification est un tube (30) à section rectangulaire muni à l'intérieur de glissières (32) pour recevoir ledit au moins un circuit imprimé (34).

7. Module selon la revendication 3, caractérisé en ce qu'il comprend un bloc de test intégrant pour chaque point de test une pointe à ressort.

8. Module selon la revendication 7, caractérisé en ce que chaque point de test du bloc de test (52) comprend une pointe à ressort (76) reliée à un conducteur dénudé d'une limande (70) de fils par l'intermédiaire d'un contact (73) à double tête tulipe.

9. Module selon la revendication 7, caractérisé en ce que chaque point de test du bloc de test (52) comprend une pointe à ressort (76) insérée dans un contact à tête tulipe (84) qui est brasé sur une pastille (18) d'un substrat (52-1).

10. Module selon la revendication 9, caractérisé en ce que ledit substrat (52-1) comporte sur la face opposée des puces nues (88) de circuit intégré reliées par des fils à des pistes gravées sur ladite face opposée.
